# EUROPEAN PATENT SPECIFICATION

(11) **EP 1 945 012 B1**
(45) Date of publication and mention of the grant of the patent: **24.09.2014**
(21) Application number: 07100338.8
(22) Date of filing: 10.01.2007
(51) Int. Cl.: H01L 33/62, H05K 3/24, H01L 21/60, H05K 1/18

(54) **LED module with gold bonding**
LED-Modul mit Goldkontaktierung
Module à DEL avec connexion en or

(43) Date of publication of application: 16.07.2008
(73) Proprietor: Tridonic Jennersdorf GmbH, 8380 Jennersdorf (AT)
(72) Inventor: Hoschopf, Hans, 8380 Jennersdorf (AT); Tasch, Stefan, 8380 Jennersdorf (AT)
(74) Representative: Rupp, Christian

(56) References cited:
- EP-A1- 0 526 656
- DE-U1- 20 008 346
- JP-A- 2000 188 461
- JP-A- 2005 183 462
- US-A- 5 801 436
- US-A1- 2004 227 258
- US-A1- 2005 001 324
- US-A1- 2005 073 048
- US-B1- 6 519 845
- Brad Durkin ET AL: "ELECTROLESS DEPOSITION" In: "Kirk-Othmer Encyclopedia of Chemical Technology", 16 July 2004 (2004-07-16), John Wiley & Sons, Inc., XP055088272, pages 685-727, DOI: 10.1002/0471238961.0512050311182112.a01.pu b2, * page 687, line 3 - line 19 *

## Description

The present invention generally relates to the field of light emitting diodes (LEDs) and especially to the field of bonding LED chips mounted in chip-on-board (COB) technology on a printed wiring board (PWB).

In the following the LED chip will also be called a LED die. A die in the context of integrated circuits is a small piece of semiconducting material on which a given circuit is fabricated, in the present case a LED. A wavers cut into many pieces, each containing one copy of the integrated circuit that is being produced, each of these pieces being called a "die".

LED modules in COB technology have advantages regarding the thermal management and the optical characteristics. On the other hand, there are some restrictions conditional to this technology. One aspect actually is the direct exposure of the semiconductor (LED chip) to environmental influences. To improve the optical performance of a LED, the only protection between the semiconductor and the ambience usually is a highly transparent coating with the fundamental requirement for unimpeded pass of the light generated from the LED. Additional constraints on this coating are UV stability, thermal and chemical resistance as well as mechanical stability. The mechanical stability is a particular issue due to the coating material ("globe top"). According to the COB LED technology, the semiconductor (LED) is fixed on the PWB by an adhesive. After curing of this adhesive, the electrical contact between the semiconductor chip and the PWB has to be established. This is done by bonding.

So-called "ball bonding processes" can use a combination of heat, pressure, and ultrasonic energy to make a weld at each end of the bond wire. A ball bonding machine comprises a capillary, through which the wire is fed. A high-voltage electric charge is applied to the wire melting the wire at the tip of the capillary. The tip of the wire forms into a ball which quickly solidifies, and the capillary is lowered to the surface of the LED chip. The ball bonding machine then pushes down on the capillary and applies ultrasonic or thermosonic energy. The applied energy creates a weld between the gold ball and the surface of the LED chip. Thus the so-called ball bond contact is created.

Next the wire is passed out through the capillary and the machine moves the location of the PWB that the LED chip needs to be wired up to. The machine again descends to the surface, this time without making a ball so that the wire is crushed between the PWB surface and the tip of the capillary. The surface can be of gold. The resulting weld, due to its appearance is called a wedge bond contact. Also for the wedge bond contact an ultrasonic or thermosonic gold wire ball wedge bond process can be used.

"Landing pad" designates the second bonding contact, which usually is the contact between the bond wire and the PWB.

Thermosonic bonding comprises the additional step the heating of the substrate thus improving the bonding quality, but asking for an additional time period for the heating process. The condition of the surface of the "landing pad" determines the quality of the second (wedge) bond.

The surface of the landing pad (wedge contact) is an important factor as to the electrical or mechanical characteristics of the bonding. As the ball bond contact applied onto the LED chip is a mechanically strong connection, the wedge contact of the bond wire on the board can represent the mechanical and/or electrical "bottle neck" of the COB assembly. In order to generate the wedge contact, the gold wire is squeezed by a ceramic capillary into the gold surface of the landing pad. From the bonding machine the applied power, force and time are essential for the quality of the connection. However, an acceptable connection also largely depends on the quality of the landing pad surface. A poor quality of the surface can be caused e.g. by organic and/or inorganic contamination of the landing pad surface. In connection with the COB assembly, the wedge contact and the quality of the surface of the landing pad are the key factors for excellent product performance. In the field of LED modules, particularly with an optically transparent coating of the LED die, there are particular mechanical and electrical constrains on the bonding.

E.g., the COB assembly should withstand pull forces of several grams, such as for example pull forces of more than 4 to 10 g.

The ball and/or wedge contacts should withstand shear forces of e.g. more than 10 to 20 g.

In order to use the COB assembly for high power LEDs, the bonding should be able to carry currents up to a range of up to between 300 and 800 mA.

US 6733823 teaches a method of electrolessly gold plating copper on a printed circuit board (PCB). Starting with a copper patterned PCB, steps include: clean with ultrasonic agitation with the PCB initially oriented vertically and gradually moved to a 45.degree. angle; rinse; sulfuric acid bath with ultrasonic and mechanical agitation; rinse; another sulfuric acid bath with ultrasonic and mechanical agitation; plate the copper with palladium with ultrasonic agitation with the PCB initially oriented at a 45.degree. angle and flipped half way through to opposing 45.degree. angle; rinse; post dip in sulfuric acid; rinse; electrolessly nickel plate with mechanical agitation; rinse; nitrogen blow dry; visual inspection for nickel coverage of the copper; hydrochloric acid bath with manual agitation; rinse; if full nickel coverage was not achieved, repeat preceding steps starting with second sulfuric acid bath; gold flash plate to establish a first layer of gold; rinse; autocatalytic gold plate; rinse; and nitrogen blow dry.

The process known from US 6733823 can be used in connection with the present invention.
JP 2005/183462 relates to a wiring board, to which a bonding wire having a diameter of 100 µm or more is bonded, permitting flow of relatively high currents of 5A and higher. The wiring board comprises a nickel layer covered by further layers of palladium and a single gold layer.

DE 200 08 346 U1 describes a state-of-the-art chip on board (COB) arrangement of LED chips on copper wirings, wherein a gold bonding wire is connected to a gold bond pad.

US 6 519 845 B1 relates to a carrier substrate with a wire bond pad formed on copper traces comprising a first isolating nickel layer and a palladium layer arranged thereon. An immersion gold layer is arranged above the palladium layer.
US 2005/001324 relates to a capped copper bond pad on a semiconductor substrate comprising a plurality of layers thereon, in particular an activation layer of immersion palladium, cobalt or ruthenium, a first intermediate layer of electroless nickel-boron alloy, a second intermediate layer of electroless palladium and an immersion gold layer, which may be plated with an additional electrolessly or autocatalytically plated gold layer.

In view of the above constrains, it is the object of the present invention to provide for an improved LED module, which is mounted in chip-on-board technology and wherein the bonding technology is particularly adapted to the requirements of LEDs.

This object is achieved by means of the features of the independent claims 1 and 7, which define the present invention. The dependent claims develop further the central idea of the present invention.

A first aspect of the present invention relates to a LED module comprising at least one LED chip mounted on a printed wiring board in chip-on-board technology. The at least one LED chip is bonded to the board with a golden bond wire. The golden bond wire is bonded on a gold layer of the board, the gold layer having a thickness of less than 0.20 µm. It has been shown that this gold wire bonding fits better the requirements on LED chips.

Preferably the gold bond wire has a thickness of between 15 and 50 µm.

The printed wiring board comprises copper layers as electrical conductors.

The copper layers are covered by a nickel layer.

The nickel layer is covered by a palladium layer, which in turn is covered by the thin gold layer.

The contact with the gold wire and the gold surface of the board is preferably a wedge bonding contact.

The gold layer can have a thickness of less than 0.15 µm, preferably less than 0.10 µm.

The bonding can be designed in order to carry at least a current of 300 mA, preferably 500mA.

The bonding is designed to withhold the mechanical pull force of 5 to 10 g.

The LED chip can be encapsulated with a transparent material.

The gold layer comprises a first layer of immersion gold (in German language "Sudgold") as well as a second (top) layer of autocatalytically plated gold top layer arranged on the electrolessly plated gold layer.

A further aspect of the present invention relates to a method for providing a high current, high mechanical stress resistant bonding of a LED chip mounted on a printed wiring board in COB technology. The method comprises the step of providing the board with a gold top layer having a thickness of less than 0.20 µm. A second step bonds the LED die using a gold bond wire.

Further aspects, features and advantages of the present invention will become evident for the skilled person when going through the following detailed description of a preferred embodiment taking in conjunction with the figure of the enclosed drawings.
Figure 1 shows a schematic view of a LED module comprising a LED chip mounted in chip-on-board technology on a printed wiring board,
Figure 2 shows schematically the nickel/palladium and gold layers of the present invention, and
Figure 3 shows schematically a thermosonic or ultrasonic welding which can be used in connection with the present invention.

In the recent past the interest in chip-on-board solutions has increased. One of the reason is that this approach will favourable for a thermal management of components even in a very dense assembly of the components, which is advantageous for miniaturizations in many applications. For that reasons COB solutions are often used in environments with extreme environmental temperature and/or in high power ranges. For such applications it is often necessary to have a highly reliable contact which is also capable of conducting high currents. According to the state of the art therefore often gold contacts are applied combining high corrosive strength and excellent electric conductive properties.

According to the state of the art the gold contacts on the component (e.g. LED chip) are contacted by gold wires and then, in a second step, connected to the printed wiring board (PWB). The PWB can consist of an organic, metallic, or ceramic core covered with metallic layers. In many cases the core is covered with copper layers for electrical conduction. Since copper is not stable under environmental conditions, it is usually protected with some surface finishing. For COB solutions this surface finishing is based usually on metal layers. Typically there is used nickel as the barrier layer and the gold layer to passivate the surface of nickel. For gold wire bonding the final gold layer on the board has to be in the order of 0.3 µm and more. Due to the high costs of gold the thickness of the gold layer on the board is responsible that gold wire bonding solutions are typically more expensive than AL wire bonding solutions, which are therefore often used in technical applications even if the reliability is inferior to those of the gold wire bonding.

As will be explained later on in great detail, the invention has now found out that surprisingly a gold bonding satisfying the high requirements in the field of LED chips can be realized if the gold layer thickness is less than 0.2 µm. Thus surprisingly it has been found that the amount of gold to be used for the bonding can be reduced and at the same time a reliable gold bonding process can be realized.

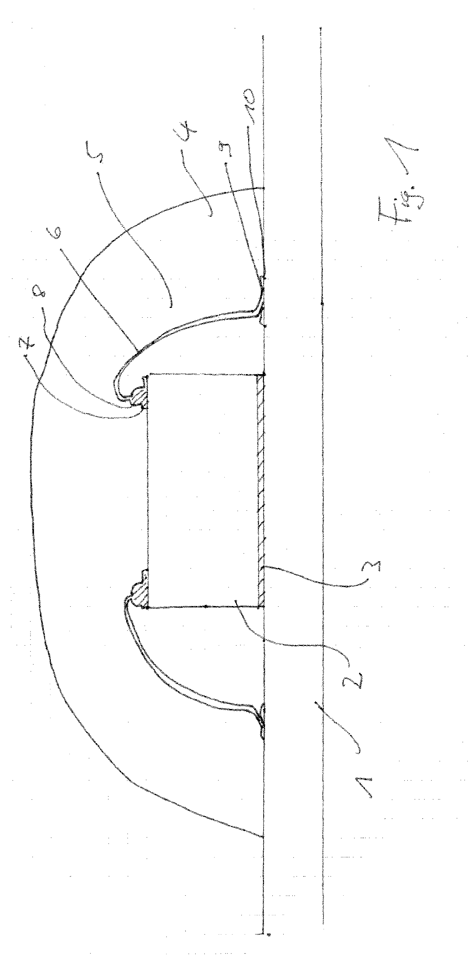

Figure 1 shows schematically a LED chip 2 which is mounted via an adhesive 3 in chip-on-board technology on a printed wiring board (PWB) 1. The LED chip 2 is covered by a transparent material 4 which can comprise a lens etc. and which can comprise wave length conversion and/or scattering particles.

In order to bond the contacts of the top surface of the LED chip 2, bonding pads 7 are provided at the top surface of the LED chip 2. These pads 7 are then connected through bond wires 6 to "landing pads" 10 on specific locations on the top surface of the PWB 1.

The bonding, including the wire and the two contacts, is generally referenced with a numeral 5.

Preferably a ball bonding 8 is used for bonding the pad 7 on the top surface of the chip 2, while preferably a wedge bonding contact 9 is used for connecting the gold bond wire 6 with the pad 10 of the PWB 1.

Preferred dimensions for the gold bond wire is a thickness of between 15 to 50 µm.

The bonding contact 8, 9 as well as the bond wire 6 itself are designed in order to carry a current of up to 500 mA and more. A typical length of the bond wire is some mm.

Preferably the printed wiring board 1 comprises copper layers as electrical conductors. These copper layers can be covered by a nickel layer, which in turn is then covered by a gold layer at the regions of the bonding contacts.

The nickel layer can be covered by a palladium layer, which is then in turn covered by the gold layer.

According to the present invention the thin gold layer at the bonding sides 10 of the printed wiring board 1 has a thickness of less than 0.20 µm and preferably less then 0.15 µm, most preferred less than 0.10 µm.

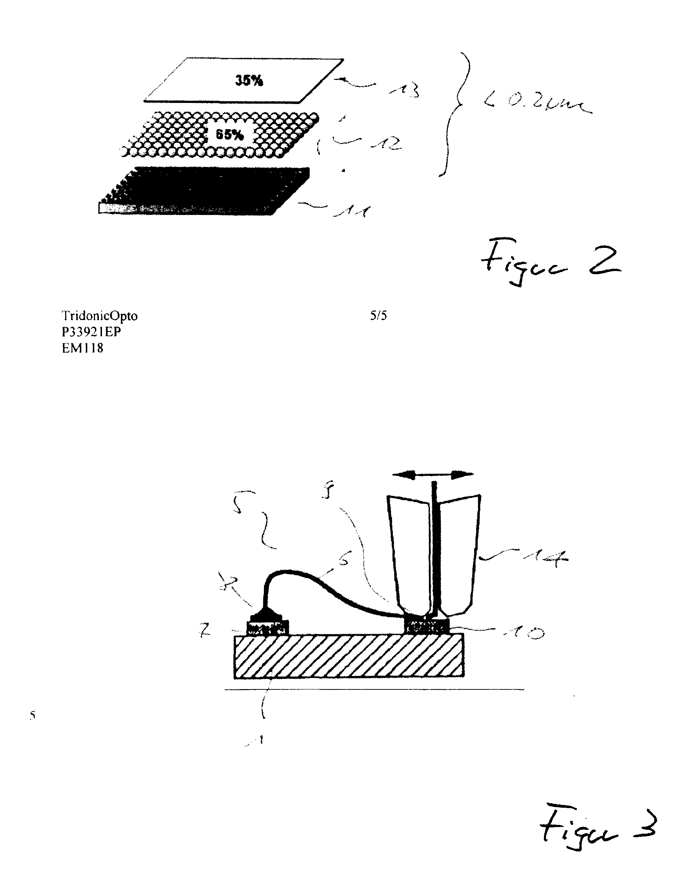

Figure 2 shows the nickel/palladium layer 11 as well as the gold layer comprised of two different layers 12, 13 according to the present invention. Usually the palladium is deposited on the copper surfaces before the nickel layer is plated electrolessly.)

The lower gold layer 12 is made from electrolessly plated gold (in German language "Sudgold") and can constitute some 65 % of the total amount of gold used for the gold layer. As can be schematically seen in figure 2, the immersion gold layer 12 is not very smooth, such that an autocatalytically plated gold layer 13 is applied on top of the immersion gold layer 12. It is the combination of the autocatalytic top layer 13 and the immersion gold layer 12 which enables a good mechanical and electrical contacting of the bond contacts as well as a good passivation of the nickel palladium layer below.

Preferably the composite thickness of the immersion gold layer 12 and the autocatalytic top layer 13 is less than 0.2 µm.

The thickness of the Nickel layer 11 can be e.g. 5µm.

Figure 3 shows schematically how an ultrasonic or thermosonic process can be used in order to procure the wedge bonding contact 9 at the pads 10 arranged on the PWB board 1. The gold wire 6 is held by a capillaric device 14, which is made to vibrate through ultrasonic sound, the friction caused by the vibration partially melting the gold wire 6 into the pad 10.

## Claims

1. A LED module comprising at least one LED chip mounted on a printed wiring board (1) in chip-on-board technology, wherein
- the at least one LED chip (2) is bonded to the board with a bond wire (6),
- the bond wire (6) is made from gold,
- and the gold bond wire (6) is bonded on a gold layer (12,13) arranged over a copper portion of the board
- the printed wiring board comprises copper layers as electrical conductors,
- the copper layers are covered by a nickel layer (11), and
- the nickel layer (11) is covered by a palladium layer which in turn is covered by said gold layer (12,13), wherein the gold layer comprises two different layers (12,13), a first immersion gold layer (12) and a second autocatalytically plated gold top layer (13), the gold layer (12,13) having a composite thickness of less than 0.20µm, and
wherein the bonding (5) is designed to withhold a mechanical pull force of 5 to 10 grams.

2. The LED module according to claim 1,
wherein the gold bond wire (6) has a thickness of between 15 and 50µm.

3. The LED module according to any of the preceding claims,
wherein the contact between the gold wire (6) and the gold surface (12,13) of the board is a wedge bonding contact (9).

4. The LED module according to any of the preceding claims,
wherein the gold layer has a thickness of less than 0.15µm, preferably less than 0.10µm.

5. The LED module according to any of the preceding claims,
wherein the bonding (9) is designed to carry at least a current of 500mA.

6. The LED module according to any of the preceding claims,
wherein the LED chip (2) is encapsulated with a transparent material (4).

7. A method for supplying with current a LED chip mounted on a printed wiring board in chip-on-board-technology, wherein the printed wiring board comprises copper layers as electrical conductors,
the method comprising the steps of:
- covering the copper layers by a nickel layer,
- covering the nickel layer by a palladium layer,
- covering the palladium layer with a first immersion gold layer (12),
- providing a second autocatalytically plated gold layer (13) on top of the immersion gold layer (12),
- wherein the first and second gold layers (12,13) have a composite thickness of less than 0.20µm,
- bonding the LED chip using a gold bond wire to the gold layers (12,13), wherein the bonding (5) is designed to withhold a mechanical pull force of 5 to 10 grams,
the method furthermore comprising the step of supplying the LED chip with a current of more than 300mA.

8. The method according to claim 7,
wherein a gold wire (6) having a thickness of between 15 and 50µm is used.

9. The method according to claim 7 or 8,
wherein a ultrasonic or thermosonic bonding is carried out.

10. The method according to any of claims 7 to 9,
wherein a gold wire ball wedge bonding is used.

## Patentansprüche

1. LED-Modul, das wenigstens einen LED-Chip aufweist, der mit Chip-on-board Technologie auf eine Leiterplatte (1) montiert ist, wobei
- der wenigstens eine LED-Chip (2) durch einen Kontaktdraht mit der Platte kontaktiert ist,
- der Kontaktdraht (6) aus Gold gefertigt ist,
- und der Goldkontaktdraht (6) auf eine Goldschicht (12, 13) kontaktiert ist, die über einem Kupferabschnitt der Platte angeordnet ist,
- die Leiterplatte Kupferschichten als elektrische Leiter aufweist;
- die Kupferschichten mit einer Nickelschicht (11) überzogen sind, und
- die Nickelschicht (11) mit einer Palladiumschicht überzogen ist, die wiederum mit der Goldschicht (12, 13) überzogen ist,
wobei die Goldschicht zwei verschiedene Schichten (12, 13), eine erste Immersionsgoldschicht (12) und eine zweite autokatalytisch metallisierte oberste Goldschicht (13) aufweist, wobei die Goldschicht (12, 13) eine zusammengesetzte Dicke von weniger als 0,20 µm hat, und
wobei die Kontaktierung (5) konzipiert ist, um einer mechanischen Zugkraft von 5 bis 10 Gramm standzuhalten.

2. LED-Modul nach Anspruch 1,
wobei der Goldkontaktdraht (6) eine Dicke zwischen 15 und 50 µm hat.

3. LED-Modul nach einem der vorhergehenden Ansprüche, wobei der Kontakt zwischen dem Golddraht (6) und der Goldoberfläche (12, 13) der Platte ein Wedge-Bonding-Kontakt (9) ist.

4. LED-Modul nach einem der vorhergehenden Ansprüche, wobei die Goldschicht eine Dicke von weniger als 0,15 µm, vorzugsweise weniger als 0,10 µm hat.

5. LED-Modul nach einem der vorhergehenden Ansprüche, wobei die Kontaktierung (9) konzipiert ist, um wenigstens einen Strom von 500 mA zu befördern.

6. LED-Modul nach einem der vorhergehenden Ansprüche, wobei der LED-Chip (2) in einem transparenten Material (4) eingekapselt ist.

7. Verfahren zur Versorgung eines LED-Chips, der mit Nacktchipmontagetechnologie auf eine Leiterplatte (1) montiert ist, mit Strom, wobei
die Leiterplatte Kupferschichten als elektrische Leiter aufweist,
wobei das Verfahren die folgenden Schritte aufweist:
- Überziehen der Kupferschichten mit einer Nickelschicht,
- Überziehen der Nickelschicht mit einer Palladiumschicht,
- Überziehen der Palladiumschicht mit einer ersten Immersionsgoldschicht (12),
- Bereitstellen einer zweiten autokatalytisch metallisierten Goldschicht (13) oben auf der Immersionsgoldschicht (12),
- wobei die ersten und zweiten Goldschichten (12, 13) eine zusammengesetzte Dicke von weniger als 0,20 µm haben,
- Kontaktieren des LED-Chips unter Verwendung eines Goldkontaktdrahts mit den Goldschichten (12, 13), wobei die Kontaktierung (5) konzipiert ist, um einer mechanischen Zugkraft von 5 bis 10 Gramm standzuhalten,
wobei das Verfahren außerdem den Schritt des Versorgens des LED-Chips mit einem Strom von nicht mehr als 300 mA aufweist.

8. Verfahren nach Anspruch 7,
wobei ein Golddraht (6) mit einer Dicke zwischen 15 und 50 µm verwendet wird.

9. Verfahren nach Anspruch 7 oder 8,
wobei eine Kontaktierung durch Ultraschall- oder Wärme und Ultraschall ausgeführt wird.

10. Verfahren nach einem der Ansprüche 7 bis 9,
wobei ein Ball-Wedge-Bonding mit Golddraht verwendet wird.

## Revendications

1. Module de LED comprenant au moins une puce à LED montée sur une carte de circuit imprimé (1) selon la technologie chip-on-board, dans lequel
- ladite au moins une puce à LED (2) est liée à la carte avec un fil de connexion (6),
- le fil de connexion (6) est réalisé à partir d'or,
- et le fil de connexion en or (6) est lié sur une couche en or (12, 13) agencée au-dessus d'une partie en cuivre de la carte
- la carte de circuit imprimé comprend des couches de cuivre comme conducteurs électriques,
- les couches de cuivre sont recouvertes par une couche de nickel (11), et
- la couche de nickel (11) est recouverte par une couche de palladium qui est recouverte à son tour par ladite couche en or (12, 13),
dans lequel la couche en or comprend deux couches différentes (12, 13), une première couche en or d'immersion (12) et une deuxième couche en or supérieure plaquée autocatalytiquement (13), la couche en or (12, 13) présentant une épaisseur composite de moins de 0,20 µm, et
dans lequel la liaison (5) est conçue pour résister à une force de traction mécanique de 5 à 10 grammes.

2. Module de LED selon la revendication 1,
dans lequel le fil de connexion en or (6) présente une épaisseur comprise entre 15 et 50 µm.

3. Module de LED selon l'une quelconque des revendications précédentes,
dans lequel le contact entre le fil électrique en or (6) et la surface en or (12, 13) de la carte est un contact de liaison en coin (9).

4. Module de LED selon l'une quelconque des revendications précédentes,
dans lequel la couche en or présente une épaisseur inférieure à 0,15 µm, de préférence inférieure à 0,10 µm.

5. Module de LED selon l'une quelconque des revendications précédentes,
dans lequel la liaison (9) est conçue pour transporter au moins un courant de 500 mA.

6. Module de LED selon l'une quelconque des revendications précédentes,
dans lequel la puce à LED (2) est encapsulée avec un matériau transparent (4).

7. Procédé pour alimenter en courant une puce à LED montée sur une carte de circuit imprimé selon la technologie chip-on-board, dans lequel la carte de circuit imprimé comprend des couches de cuivre comme conducteur électrique,
le procédé comprenant les étapes consistant à :
- recouvrir les couches de cuivre par une couche de nickel,
- recouvrir la couche de nickel par une couche de palladium,
- recouvrir la couche de palladium par une première couche en or d'immersion (12),
- fournir, au-dessus de la couche en or d'immersion (12), une deuxième couche en or plaquée autocatalytiquement (13),
- dans lequel les première et deuxième couches en or (12, 13) présentent une épaisseur composite inférieure à 0,20 µm,
- lier la puce à LED aux couches en or (12, 13) en utilisant un fil de connexion en or, dans lequel la liaison (5) est conçue pour résister à une force de traction mécanique de 5 à 10 grammes,
le procédé comprenant en outre l'étape consistant à alimenter la puce à LED avec un courant supérieur à 300 mA.

8. Procédé selon la revendication 7,
dans lequel un fil électrique en or (6) présentant une épaisseur comprise entre 15 et 50 µm est utilisé.

9. Procédé selon la revendication 7 ou 8,
dans lequel une liaison aux ultrasons ou une liaison thermo-sonique est réalisée.

10. Procédé selon l'une quelconque des revendications 7 à 9,
dans lequel une liaison de type ball-wedge à fil électrique en or est utilisée.
